# FASCICULE DE BREVET EUROPEEN

(11) **EP 4 327 363 B1**
(45) Date de publication et mention de la délivrance du brevet: **09.12.2026**
(21) Numéro de dépôt: 22723663.5
(22) Date de dépôt: 20.04.2022
(51) Int. Cl.: F21S 43/19

(54) **MODULE LUMINEUX D'UN DISPOSITIF DE SIGNALISATION D'UN VÉHICULE AUTOMOBILE**
BELEUCHTUNGSMODUL EINER SIGNALVORRICHTUNG EINES KRAFTFAHRZEUGS
LIGHTING MODULE OF A SIGNALLING DEVICE OF A MOTOR VEHICLE

(30) Priorité: 22.04.2021 FR 2104193
(43) Date de publication de la demande: 28.02.2024
(73) Titulaire: VALEO VISION, 93012 Bobigny Cedex (FR)
(72) Inventeur: VAL, Alexandre, 93012 BOBIGNY Cedex (FR); ZOJCESKI, Zdravko, 93012 BOBIGNY Cedex (FR)
(74) Mandataire: Valeo Visibility
(86) Numéro de dépôt international: PCT/EP2022/060430
(87) Numéro de publication internationale: WO 2022/223625

(56) Documents cités:
- EP-A1- 3 203 138
- DE-A1- 102020 007 055
- LAU JOHN H: "Patent issues of embedded fan-out wafer/panel level packaging", 2016 CHINA SEMICONDUCTOR TECHNOLOGY INTERNATIONAL CONFERENCE (CSTIC), IEEE, 13 March 2016 (2016-03-13), pages 1 - 7, XP032897593, [retrieved on 20160502], DOI: 10.1109/CSTIC.2016.7463959
- KUISMA HEIKKI ET AL: "FO-WLP multi-DOF inertial sensor for automotive applications", 2018 7TH ELECTRONIC SYSTEM-INTEGRATION TECHNOLOGY CONFERENCE (ESTC), IEEE, 18 September 2018 (2018-09-18), pages 1 - 7, XP033452956, [retrieved on 20181126], DOI: 10.1109/ESTC.2018.8546447

## Description

L'invention concerne le domaine de l'éclairage et de la signalisation lumineuse automobile. Plus précisément, l'invention concerne le domaine des écrans intégrés dans des modules lumineux d'éclairage ou de signalisation lumineuse de véhicules automobiles.

Il est connu d'intégrer des écrans dans des dispositifs lumineux de véhicules automobiles, par exemple dans des feux arrière. Ces écrans sont par exemple réalisés au moyen de matrices d'un grand nombre de sources lumineuses contrôlables sélectivement, dont les dimensions sont suffisamment réduites pour qu'il soit possible d'afficher sur ces écrans des informations, par exemple sous la forme de message ou de pictogramme, avec une résolution satisfaisante. Ces informations permettent ainsi d'améliorer la signalisation du véhicule automobile, par exemple en contextualisant ou en accompagnant une fonction de signalisation donnée avec un message.

Ces sources lumineuses sont généralement montées sur un substrat, par exemple de type circuit imprimé, au dos duquel sont montés des contrôleurs permettant chacun de contrôler, de façon sélective, une partie de ces sources lumineuses. D'un point de vue thermique, de la chaleur est générée de façon importante par les sources lumineuses et doit ainsi être dissipée, afin d'éviter de dégrader leurs performances. Il va de soi que cette chaleur ne peut être dissipée du côté des sources lumineuses, et qu'elle doit dont être transmise à l'arrière du substrat. Or, la présence des contrôleurs de ce côté du substrat implique que la chaleur doit ainsi être dissipée via les faces de ces contrôleurs opposées à leurs faces de montage sur le substrat.

Pour autant, un tel contrôleur est généralement un circuit intégré encapsulé dans un boîtier, également appelé en anglais « package », permettant l'interfaçage mécanique et électrique du circuit intégré avec le substrat, et assurant la dissipation thermique de la chaleur générée par le circuit intégré. Les boîtiers des contrôleurs modernes sont généralement équipés d'une matrice de connecteurs, par exemple de type billes (également nommé BGA de l'anglais « ball grid array ») ou pastilles ( également nommé LGA, de l'anglais « land grid array ») qui est uniquement optimisée pour dissiper la chaleur du côté de la face de montage du boîtier sur le substrat. En d'autres termes, avec ce type de boîtier, la chaleur générée par les sources lumineuses et transmises aux contrôleurs via le substrat est nécessairement renvoyée vers le substrat. Dès lors, la chaleur, générée à la fois par les sources lumineuses et les contrôleurs, ne peut être dissipée de façon satisfaisante, ce qui implique que la température au sein du dispositif lumineux peut dépasser le seuil au-delà duquel les sources lumineuses de l'écran voient leurs performances dégradées.

Une solution pour pallier ce problème pourrait être de disposer les sources lumineuses et les contrôleurs de ces sources d'un même côté du substrat, de sorte à pouvoir agencer un dissipateur de chaleur de l'autre côté du substrat. Mais cette solution requiert un espace important au sein du dispositif lumineux, lequel n'est pas toujours disponible.

Le document EP 3 203 138 A1 divulgue un module lumineux pour un dispositif de signalisation d'un véhicule automobile comprenant une pluralité de sources lumineuses, montées sur une première face d'un substrat, et un contrôleur apte à contrôler sélectivement chacune desdites sources lumineuses, monté sur la deuxième face du substrat. La chaleur générée par les sources lumineuses est transmise au substrat puis aux contrôleurs, mais la configuration du boîtier du contrôleur ne permet pas d'évacuer efficacement cette chaleur vers l'extérieur.

Le document DE 10 2020 007 055 A1 divulgue un dispositif d'éclairage pour un véhicule automobile comprenant un boîtier, des diodes électroluminescentes disposées sur une platine à l'intérieur du boîtier, et une unité de commande pour les contrôler individuellement. Cependant, ce document ne propose pas de solution au problème de dissipation thermique des contrôleurs.

Des techniques de type fan out appliquées à des domaines techniques différents de celui de l'invention sont divulguées dans les documents LAU J.H., "Patent Issues of Embedded Fan-Out Wafer/Panel Level Packaging", ASM Pacific Technology, 2018, qui concerne les puces de communication sans fil, et KUISMA H. et al., "FO-WLP multi-DOF inertial sensor for automotive applications", IEEE, 2018, qui concerne les centrales inertielles. Ces documents abordent la dissipation thermique sous l'angle des avantages permis par les procédés de fabrication qu'ils évoquent mais ne proposent pas de solution adaptée à une dissipation de la chaleur intense caractéristique des dispositifs lumineux de signalisation.

Il existe ainsi un besoin pour un module lumineux capable de former un écran d'un dispositif de signalisation d'un véhicule automobile, équipé de sources lumineuses et de contrôleurs de ces sources montés respectivement de part et d'autre d'un substrat, et qui soit capable de transférer la chaleur générée par les sources lumineuses vers les contrôleurs pour être ensuite dissipée.

La présente invention se place dans ce contexte, et vise à répondre à ce besoin.

A ces fins, l'invention a pour objet un module lumineux d'un dispositif de signalisation d'un véhicule automobile, comprenant une pluralité de sources lumineuses contrôlables sélectivement ; un substrat présentant des première et deuxième faces opposées, ladite pluralité de sources lumineuses étant montées sur la première face du substrat et un contrôleur apte à contrôler sélectivement chacune desdites sources lumineuses, dans lequel le contrôleur est encapsulé dans un boîtier présentant des première et deuxième faces opposées, le boîtier étant monté, via sa première face, sur la deuxième face du substrat, dans lequel le boîtier comporte une embase métallique formant la deuxième face du boîtier, le contrôleur étant monté sur l'embase métallique, le boîtier comportant un système d'interconnexion relié directement au contrôleur et agencé pour interconnecter le contrôleur au substrat et à la pluralité de sources lumineuses et une pluralité de trous métallisés chacun relié directement à l'embase métallique et débouchant sur la première face du boîtier pour être relié au substrat.

L'invention permet ainsi d'obtenir un module lumineux dans lequel les sources lumineuses sont montées d'un côté du substrat, dans lequel un contrôleur de ces sources lumineuses est monté de l'autre côté du substrat, et propose un package ou boîtier de ce contrôleur dont les caractéristiques permettent d'extraire, de façon optimale, la chaleur émise par les sources lumineuses, pour qu'elle puisse être dissipée du côté de ce package. Plus précisément, les trous métallisés permettent d'extraire la chaleur depuis le substrat, notamment depuis les points les plus chauds du substrat, pour la transmettre à l'embase métallique. Il est à relever que l'embase métallique permet elle-même d'extraire la chaleur générée par le contrôleur. Or, cette embase métallique forme la deuxième face du boîtier, il est ainsi possible de dissiper la chaleur extraite du substrat et celle générée par le contrôleur au niveau de cette deuxième face, par exemple par convection naturelle si cette deuxième face est laissée au contact de l'air ou est équipée d'un organe de dissipation, ou encore par convection forcée au moyen d'un ventilateur.

Dans l'invention, on entend par trou métallisé un via borgne, c'est-à-dire un trou borne s'étendant sur l'épaisseur du boîtier entre la face de l'embase métallique sur laquelle est monté le contrôleur et la première face du boitier, ce trou borgne étant rempli d'un métal, par exemple du cuivre. De préférence, lesdits trous métallisés sont dépourvus de toute fonction de transport de signaux électriques, notamment générés par le contrôleur.

Avantageusement, le module lumineux comporte au moins 500 sources lumineuses, le contrôleur étant agencé pour contrôler sélectivement chacune de ces sources lumineuses. Si on le souhaite, ladite pluralité de sources lumineuses peut être une première pluralité de sources lumineuses et le contrôleur peut être un premier contrôleur, et le module lumineux peut comporter au moins une deuxième pluralité de sources lumineuses, par exemple montée sur la première face du substrat en étant adjacente à la première pluralité de sources lumineuses, et un deuxième contrôleur apte à contrôler sélectivement chacune des sources lumineuses de la deuxième pluralité, le deuxième contrôleur étant encapsulé dans un boîtier identique à celui du premier contrôleur, lequel est monté, via sa première face, sur la deuxième face du substrat.

Par exemple, le substrat peut être une carte de circuit imprimé. En variante, le substrat peut être un substrat en céramique ou en verre.

De préférence, le contrôleur est un circuit intégré. Si on le souhaite, l'embase métallique peut être réalisée en cuivre. A titre d'exemple, le boîtier pourra présenter une épaisseur, mesurée entre sa première face et sa deuxième face, inférieure à 3mm, notamment sensiblement de 600 µm, l'embase pourra présenter une épaisseur inférieure à 1,5 mm, notamment sensiblement de 300 µm, et le contrôleur pourra présenter une épaisseur inférieure à 500 µm, notamment sensiblement de 100 µm.

Dans un exemple de réalisation de l'invention, le système d'interconnexion comporte une pluralité de micro-vias agencés pour transférer des signaux électriques émis par le contrôleur et destinés à contrôler sélectivement ladite pluralité de sources lumineuses vers le substrat. On entend par micro-via un via de diamètre sensiblement inférieur ou égal à 150 µm. Le cas échéant, chaque trou métallisé pourra également présenter un diamètre sensiblement inférieur ou égal à 150 µm.

Avantageusement, le système d'interconnexion comporte une pluralité de couches superposées entre le contrôleur et la première face du boîtier, chaque couche comportant une pluralité de micro-vias connectés avec des micro-vias des couches adjacentes, par exemple par une inter-couche métallique, notamment de cuivre, formant des pistes électriques et des pastilles métalliques. En d'autres termes, le système d'interconnexion comporte une combinaison de micro-vias de ces couches, enterrés ou borgnes, étagés et/ou empilés. De préférence, chaque trou métallisé traverse ladite pluralité de couches.

Avantageusement, chaque couche du système d'interconnexion est réalisée par coulage d'une couche de matériau diélectrique sur l'embase métallique ou sur la couche précédente, par perçage laser d'une pluralité de trous dans cette couche, par remplissage de chacun des trous percés par du cuivre, et par mise en forme de pistes dans la couche de cuivre précédemment formées, ces étapes étant répétées autant de fois que le système d'interconnexion comporte de couches. De préférence, chaque trou métallisé peut ainsi être formé simultanément avec les micro-vias, ou en variante après la réalisation de la dernière couche du système d'interconnexion.

Avantageusement, le système d'interconnexion est relié au contrôleur uniquement au niveau d'une face du contrôleur opposée à la face de montage du contrôleur sur l'embase métallique. Par exemple, le contrôleur peut comporter une pluralité de plots de connexion prévus sur ladite face opposée, chaque plot de connexion venant en vis-à-vis d'un micro-via de la première couche du système d'interconnexion auquel il est relié électriquement. En d'autres termes, le contrôleur est dépourvu de connexion électrique sur sa périphérie.

Avantageusement, le système d'interconnexion comporte une matrice de connecteurs formée sur la deuxième face du boîtier, chaque connecteur étant relié électriquement au substrat. Par exemple, la matrice de connecteurs peut être une matrice de billes, également nommée BGA (de l'anglais « ball grid array »). En variante, la matrice de connecteurs peut être une matrice de pastilles, également nommée LGA (de l'anglais « land grid array »). Le cas échéant, chaque connecteur de ladite matrice peut venir en vis-à-vis d'un micro-via de la dernière couche du système d'interconnexion auquel il est relié électriquement. De préférence, chaque connecteur est relié électriquement à un élément de connexion prévu sur la deuxième face du substrat, comme un plot de connexion, une terminaison d'une piste électrique ou une pastille métallique d'un via formé dans le substrat.

Avantageusement, l'embase métallique comporte un renfoncement dans lequel est monté le contrôleur. Ce renfoncement permet notamment de simplifier la fabrication du contrôleur et d'éviter les dilations thermiques au niveau du contrôleur.

Par exemple, l'embase métallique présente une face support dans laquelle est formé le renfoncement et le contrôleur peut être agencé pour que sa face opposée à sa face de montage sur l'embase métallique affleure la face support au droit du renfoncement. De préférence, les trous métallisés s'étendent à partir de la face support de l'embase métallique, en dehors dudit renfoncement.

Avantageusement, le boîtier peut comporter au moins une couche de matériau diélectrique, par exemple réalisé en résine époxyde notamment renforcée en fibre de verre, également connu sous l'appellation FR4, ladite couche de matériau diélectrique encapsulant le contrôleur sur l'embase métallique et formant la deuxième face du boîtier. De préférence, les trous métallisés et, le cas échéant, les micro-vias sont formés dans cette au moins une couche de matériau diélectrique. Si on le souhaite, la dernière couche du système d'interconnexion, et notamment l'inter-couche métallique réalisée sur cette dernière couche, peut être recouverte d'une couche de nickel et d'une couche d'or, par exemple réalisé par un procédé de dépôt de nickel par voie autocatalytique et de dépôt d'or par immersion, procédé également connu sous le nom d'ENIG (de l'anglais « Electroless Nickel / Immersion Gold »), et/ou d'un vernis épargne.

Selon un mode de réalisation de l'invention, au moins l'un desdits trous métallisés est relié à une masse du substrat. Cette caractéristique permet ainsi de rajouter une fonction de retour à la masse aux trous métallisés, en sus de leur fonction thermique, ce qui permet par exemple à l'embase métallique de jouer un rôle de blindage électromagnétique. Par exemple, le substrat peut comporter un plan de masse formé par une couche interne du substrat reliée à la masse, et une pluralité de vias traversants et/ou borgnes agencés dans le substrat pour être connectés à ce plan de masse. Le cas échéant, ledit au moins un trou métallisé débouche sur la première face du boîtier pour être relié électriquement à un connecteur, notamment à un connecteur de ladite matrice de connecteurs, ledit connecteur étant relié électriquement à la pastille métallisé, prévue sur la deuxième face du substrat, d'un desdits vias du substrat connectés au plan de masse.

Avantageusement, au moins deux desdits trous métallisés débouchent sur la première face du boîtier au niveau d'un même connecteur auquel ces trous métallisés sont électriquement reliés. Grâce à cette caractéristique, lesdits trous métallisés sont groupés et jouent ainsi le rôle de résistances thermiques montées en parallèle, ce qui permet d'accroitre la résistance thermique du groupe.

Selon un mode de réalisation de l'invention, le module lumineux comprend un organe de dissipation thermique sur lequel est monté ledit boîtier via sa deuxième face. Ledit organe de dissipation thermique peut comporter une pièce en matériau conducteur thermiquement, notamment en aluminium, par exemple pourvu d'ailettes de dissipation. Le cas échéant, ladite deuxième face peut être recouverte d'une couche d'or ou de nickel, via laquelle ladite pièce en matériau conducteur thermiquement peut être soudée au boîtier. De façon alternative ou cumulative, l'organe de dissipation thermique peut comporter un organe de ventilation.

Dans un mode de réalisation de l'invention, chacune des sources lumineuses comporte au moins une puce à semi-conducteur émettrice de lumière dont les dimensions sont comprises entre 150 µm et 400 µm. Une telle puce répond notamment au nom de miniled. Le cas échéant, les sources lumineuses peuvent être agencées sur la première face du substrat de sorte à être distantes les unes des autres d'une distance inférieure à 1 millimètre. En variante, chacune des sources lumineuses comporte au moins une puce à semi-conducteur émettrice de lumière dont les dimensions sont comprises entre 5 µm et 150 µm. Une telle puce répond notamment au nom de microled. Le cas échéant, les sources lumineuses peuvent être agencées sur la première face du substrat de sorte à être distantes les unes des autres d'une distance comprise entre 200 et 400 µm, voire inférieur ou égal à 300 µm. On entend ici par « distance entre deux sources lumineuses », la distance séparant le centre de l'une de ces sources lumineuses au centre de l'autre de ces sources lumineuses.

Avantageusement, le module lumineux comporte un connecteur pour recevoir une instruction de contrôle de ladite pluralité de sources lumineuses, par exemple émise par un calculateur du véhicule automobile ou du dispositif de signalisation. Le cas échéant, la pluralité de sources lumineuses peut former une matrice passive et le contrôleur peut être agencé pour contrôler ladite matrice passive en fonction de l'instruction de contrôle reçue par le connecteur. Par exemple, le module lumineux peut comporter une pluralité de dispositifs de pilotage de l'alimentation électrique fournie aux sources lumineuses, chaque dispositif de pilotage étant monté sur la première face du substrat au droit d'une source lumineuse pour piloter l'alimentation électrique fournie à la source lumineuse, notamment en fonction d'une instruction reçue du contrôleur qui lui est destinée.

L'invention a également pour objet un dispositif de signalisation d'un véhicule automobile, caractérisé en ce qu'il comporte un module lumineux selon l'invention, ladite pluralité de sources lumineuses formant un écran lumineux dudit dispositif de signalisation.

La présente invention est maintenant décrite à l'aide d'exemples uniquement illustratifs et nullement limitatifs de la portée de l'invention, et à partir des dessins annexés, dessins sur lesquels les différentes figures représentent :
[Fig. 1] représente, schématiquement et partiellement, une vue de côté d'un module lumineux selon un exemple de réalisation de l'invention ;
[Fig. 2] représente, schématiquement et partiellement, une vue de côté du contrôleur de la [Fig. 1] encapsulé dans son boîtier.

Dans la description qui suit, les éléments identiques, par structure ou par fonction, apparaissant sur différentes figures conservent, sauf précision contraire, les mêmes références.

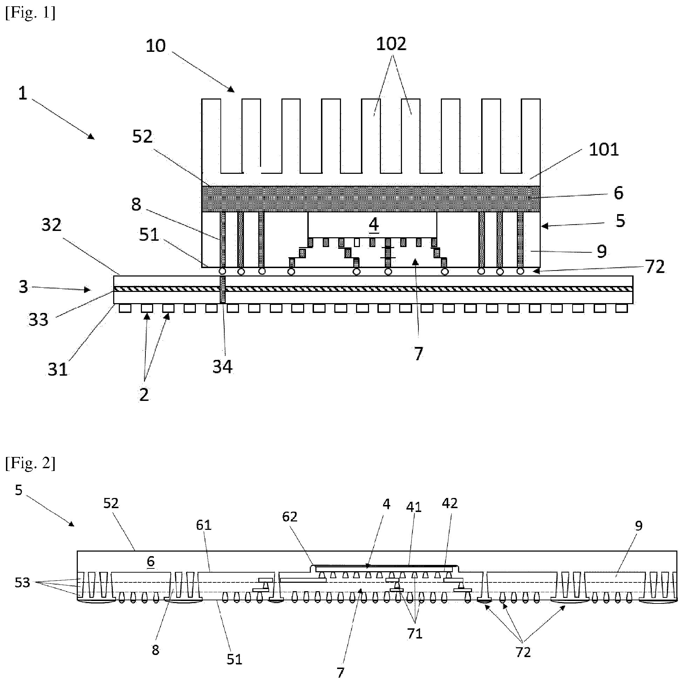

On a décrit en [Fig. 1] une vue de côté d'un module lumineux 1 selon un mode de réalisation de l'invention. Dans l'exemple décrit, ce module lumineux 1 est destiné à être intégré dans un feu arrière d'un véhicule automobile, le module lumineux 1 formant un écran.

Le module lumineux 1 comprend une pluralité de sources lumineuses 2 montées sur un substrat 3.

Dans l'exemple décrit, chacune des sources lumineuses 2 comporte au moins une puce à semi-conducteur émettrice de lumière, dite microled, dont les dimensions sont comprises entre 5 µm et 150 µm. Le module lumineux 1 comporte plus de 20000 sources lumineuses 2, agencées de façon matricielle, sur 256 colonnes et 80 lignes, les sources lumineuses 2 étant distantes les unes des autres d'une distance inférieur ou égale à 300 µm. Il est à noter qu'on pourra envisager d'autres dimensions des sources lumineuses, d'autres distances entre les sources lumineuses, d'autres nombres de sources lumineuses ou encore d'autres répartitions des sources lumineuses, sans sortir du cadre de la présente invention.

Le substrat 3 est une carte de circuit imprimé, ou PCB, présentant une première face 31 et une deuxième face 32 opposée à la première face. Les sources lumineuses 2 sont montées sur la première face 31 du substrat, laquelle fait face à l'extérieur du dispositif de signalisation dans lequel est intégré le module lumineux 1.

Il est à noter que, dans l'exemple décrit, le substrat 3 est un PCB dit multicouche, comportant un empilement de couches, entre les première et deuxième faces 31 et 32. Ces couches sont notamment destinées à l'interconnexion des composants montés sur le PCB. L'une de ces couches, interne, forme un plan de masse 33 en étant reliée à une masse électrique. Le substrat 3 comporte une pluralité de vias 34 traversants, borgnes ou enterrés, agencés dans le substrat 3 pour être connectés aux différentes couches d'interconnexion et à ce plan de masse 33. Ces vias 34 débouchent sur la deuxième face 32 du substrat 3 au niveau de pastilles métalliques auxquelles ils sont reliés.

Afin de pouvoir contrôler les sources lumineuses 2, le module lumineux 1 comporte une pluralité de contrôleurs 4. Sur la [Fig. 1], un seul contrôleur 4 a été représenté, étant entendu que tous les contrôleurs 4 présentent une structure identique les uns aux autres. Chaque contrôleur 4 est apte à contrôler sélectivement chacune des sources lumineuses 2 d'un groupe de sources lumineuses 2. Dans l'exemple décrit, chaque contrôleur 4 peut ainsi contrôler sélectivement une matrice de 64x64, soit 4096, sources lumineuses 2.

Le module lumineux 1 comporte un connecteur (non représenté) pour recevoir une instruction de contrôle de ladite pluralité de sources lumineuses 2. Il peut par s'agir d'une instruction émise par un calculateur du véhicule automobile ou du dispositif de signalisation pour l'affichage d'un logo, d'un message, d'un motif ou d'un pictogramme. A titre d'exemple, il pourra s'agir d'une instruction d'affichage d'un pictogramme destiné à informer un observateur extérieur de l'ouverture d'une portière du véhicule automobile, d'un pictogramme destiné à informer un automobiliste suivant le véhicule automobile de la présence de verglas sur la route ou encore d'une information relative au trafic automobile.

La pluralité de sources lumineuses 2 forme une matrice passive où chaque ligne et chaque colonne de sources lumineuses 2 est associée à un dispositif de pilotage monté sur la première face 31 du substrat 3 au droit de cette ligne ou de cette colonne pour piloter l'alimentation électrique fournie aux sources lumineuses de cette ligne ou de cette colonne. Le contrôleur 4 est ainsi agencé pour contrôler chacune des sources 2 de ladite matrice passive en fonction de l'instruction de contrôle reçue par le connecteur, en balayant successivement les lignes puis les colonnes de la matrice pour contrôler l'alimentation électrique fournie à chacune des sources lumineuses 2.

Chaque contrôleur 4 est un circuit intégré, ou « IC » 'de l'anglais « Integrated Circuit »), encapsulé dans un boîtier 5, également appelé « package », via lequel ce contrôleur 4 est monté sur le substrat 3. Plus précisément, le boîtier 5 comporte une première face 51 et une deuxième face 52 opposée à la première face, le boîtier 5 étant monté, via sa première face 51, sur la deuxième face 32 du substrat 3.

Ce contrôleur 4 et son boîtier 5 vont maintenant être décrit, en liaison avec la [Fig. 2] qui montre une vue en coupe de cet ensemble.

Le boîtier 5 comporte une embase métallique 6, réalisée en cuivre et formant la deuxième face 52 du boîtier 5. L'embase métallique 6 présente une face support 61, opposée à cette deuxième face 52, dans laquelle est formé un renfoncement 62. Le contrôleur 4 est agencé dans ce renfoncement 62, par exemple en étant fixé au moyen d'une colle conductrice thermiquement, par exemple à base époxyde, par une colle obtenue par frittage, ou par soudure ou encore par brasage. Le contrôleur présente ainsi une face de montage 41, via laquelle il est monté dans le renfoncement 62, et une face de connexion 42, opposée à la face de montage 41, le renfoncement 62 et/ou le contrôleur 4 étant dimensionné de sorte que cette face de connexion 42 affleure la face support 61 au droit du renfoncement 62. L'embase métallique 6 a pour fonction, entre autres, de collecter la chaleur générée par le contrôleur 4

Le boîtier 5 comporte également un système d'interconnexion 7 permettant d'interconnecter le contrôleur 4 et le substrat 3, de sorte à transférer des signaux électriques émis par le contrôleur 4, destinés à contrôler sélectivement ladite pluralité de sources lumineuses 2, vers le substrat 3 et vers ces sources lumineuses 2.

A ces fins, le boîtier 5 comporte une pluralité de couches 53 superposées entre le contrôleur 4 et la première face 51 du boîtier, chaque couche comportant une pluralité de micro-vias 71 connectés avec des micro-vias des couches adjacentes, supérieure et inférieure, par des pistes de cuivres. Ces couches de micro-vias, enterrés ou borgnes, étagés et/ou empilés, forment ledit système d'interconnexion 7.

Dans l'exemple décrit, le contrôleur 4 présente, sur sa face de connexion 42, une pluralité de plots de connexion. Chaque plot de connexion vient en vis-à-vis d'un micro-via 71 de la première couche 53 du système d'interconnexion 7 auquel il est relié électriquement, par exemple par soudage. Il est à noter que, dans l'exemple de la [Fig. 2], le système d'interconnexion 7 est relié au contrôleur 4 uniquement au niveau de la face de connexion 42, et qu'il n'y a aucune connexion électrique sur la périphérie du contrôleur 4.

Le système d'interconnexion 7 comporte une matrice de connecteurs 72 formée sur la deuxième face 52 du boîtier 5. Dans l'exemple de la [Fig. 2], la matrice de connecteurs 72 est une matrice de billes, également nommée BGA (de l'anglais « ball grid array »). Chaque connecteur 72 vient en vis-à-vis d'un micro-via 71 de la dernière couche 53 auquel il est relié électriquement, par exemple par soudage. Chaque connecteur est également relié électriquement à un élément de connexion prévu sur la deuxième face 32 du substrat, comme un plot de connexion, une terminaison d'une piste électrique ou une pastille métallique d'un via 34.

Le boîtier 5 comporte une pluralité de trous métallisés 8, reliés chacun à l'embase métallique 6 et débouchant sur la première face 51 du boîtier.

Chaque trou métallisé 8 s'étend dans l'épaisseur du boîtier 5, à partir de la face support 61 de l'embase 6 et en dehors du renfoncement 62, de sorte que le métal remplissant ces trous soit relié à l'embase 6.

Chaque trou métallisé 8 traverse ladite pluralité de couches 53 pour déboucher au niveau de la première face 51 du boîtier 5. Dans l'exemple de la [Fig. 2], certains trous métallisés 8 débouchent chacun au niveau de la première face 51 au niveau d'un connecteur 72 de ladite matrice de connecteur 72. D'autres trous métallisés 8 sont groupés et débouchent sur la première face 51 au niveau d'un même connecteur 72.

Il est à noter que les trous métallisés 8 permettent d'extraire la chaleur depuis le substrat 3, et notamment la chaleur générée par les sources lumineuses 2, pour la transmettre à l'embase métallique 6. Ces trous métallisés sont dépourvus de toute fonction de transport de signaux électriques générés par le contrôleur 4.

En revanche, dans l'exemple de la [Fig. 1], au moins l'un des trous métallisés 8 débouche sur la première face 51 pour être relié électriquement, via un connecteur 72, à l'un desdits vias 34 du substrat 3 connectés au plan de masse 33. Ce trou métallisé 8 vient ainsi connecter l'embase 6 à la masse.

L'ensemble des micro-vias 71 et des trous métallisés est noyé dans une couche de matériau diélectrique 9, par exemple réalisé en résine époxyde notamment renforcée en fibre de verre, également connu sous l'appellation FR4. Cette couche de matériau diélectrique 9 encapsule le contrôleur 4 sur l'embase métallique 6 et forme ainsi la première face 51 du boîtier 5.

Un exemple de procédé de fabrication du boîtier 5 de la [Fig. 2] va maintenant être décrit.

Dans une première étape, le circuit intégré 4, sous la forme d'un « die », est assemblé à l'embase métallique 6, dans le renfoncement 62.

Une couche 9 de matériau diélectrique est coulée sur l'embase métallique 6, sur sa face . Une pluralité de trous sont ensuite percés dans cette couche 9, par exemple par perçage laser. Il est à noter que, puisque l'embase métallique 6 ainsi que les plots de connexion prévus sur la face de connexion 42 du circuit intégré 4 sont réalisés en cuivre, le laser est réfléchi par l'embase et par ces plots, de sorte que les trous percés par ce laser lors de cette étape ne s'étendent pas au-delà de cette embase et de ces plots.

Une couche de cuivre est alors déposée sur la couche 9 de matériau diélectrique, pour remplir les trous et former la première couche 53 de micro-vias 71. Le surplus de cuivre au-dessus de la couche 9 est mis en forme, par découpage, pour former des pistes de cuivre destinées à l'interconnexion des micro-vias 71 de cette première couche 53 avec la couche suivante.

Ces étapes de coulage de la couche 9 de matériau diélectrique, de perçage de trous, de dépôt d'une couche de cuivre, et de mise en forme du surplus de cuivre sont répétées autant de fois que nécessaire pour former le système d'interconnexion 7.

Les trous métallisés 8 pourront être formés simultanément avec le système d'interconnexion 7, le laser reperçant alors la couche 9 au niveau de chacun trou métallisé 8 précédemment formé lors de l'itération précédente. En variante, les trous métallisés seront percés en une fois à la fin de la réalisation de la dernière couche 53 du système d'interconnexion 7.

A l'issue de la réalisation de la dernière couche 53 du système d'interconnexion 7, un vernis épargne est déposé sur la couche de matériau diélectrique 9, suivi d'une couche de nickel et d'une couche d'or, par exemple réalisé par un procédé de dépôt de nickel par voie autocatalytique et de dépôt d'or par immersion, procédé également connu sous le nom d'ENIG (de l'anglais « Electroless Nickel / Immersion Gold »). Enfin, les connecteurs 72 sont formés sur cette couche de nickel et or.

On notera que le boîtier 5 pourra présenter une épaisseur, mesurée entre sa première face 51 et sa deuxième face 52, inférieure à 3mm, notamment sensiblement de 600 µm. L'embase métallique 6 pourra présenter une épaisseur, mesurée entre la première face 51 et sa face support 61, inférieure à 1,5 mm, notamment sensiblement de 300 µm, et le contrôleur 5 pourra présenter une épaisseur, mesurée entre sa face de montage 51 et sa face de connexion 42, inférieure à 500 µm, notamment sensiblement de 100 µm.

Dans l'exemple de la [Fig. 1], le module lumineux 1 comprend un organe de dissipation thermique 10 sur lequel est monté ledit boîtier 5 via sa deuxième face 52. Cet organe de dissipation thermique 10 est une pièce 101 en matériau conducteur thermiquement, notamment en aluminium, par exemple pourvu d'ailettes de dissipation 102. L'embase métallique 6 a été recouverte d'une couche d'or ou de nickel, au niveau de la deuxième face 52, via laquelle ladite pièce 101 est ainsi soudée au boîtier.

. La description qui précède explique clairement comment l'invention permet d'atteindre les objectifs qu'elle s'est fixée, à savoir proposer un package ou boîtier d'un contrôleur de sources lumineuses d'un module lumineux d'un dispositif de signalisation de véhicule automobile, dont les caractéristiques permettent d'extraire, de façon optimale, la chaleur émise par les sources lumineuses, pour qu'elle puisse être dissipée du côté de ce package. On comprend ainsi que ces objectifs sont atteints grâce à la combinaison, au sein du boîtier du contrôleur, d'une embase métallique formant la deuxième face du boîtier et de trous métallisés permettent d'extraire la chaleur depuis le substrat, notamment depuis les points les plus chauds du substrat, pour la transmettre à l'embase métallique.

En tout état de cause, l'invention ne saurait se limiter aux modes de réalisation spécifiquement décrits dans ce document, et s'étend en particulier à tous moyens équivalents et à toute combinaison techniquement opérante de ces moyens. En particulier, on pourra prévoir un substrat en céramique ou en verre, rigide ou flexible, droit ou courbé. On pourra également prévoir d'autres types de sources lumineuses que celle décrite, et notamment des sources lumineuses de dimensions supérieures, par exemple comprise entre 150µm et 400µm, comme des microleds. On pourra envisager d'autres types de matrice de connecteurs, et notamment une matrice de pastilles, également nommée LGA (de l'anglais « land grid array »). On pourra encore envisager d'autres types d'organe de dissipation thermique que celui décrit, et notamment un organe de dissipation intégrant un organe de ventilation.

## Revendications

1. Module lumineux d'un dispositif de signalisation d'un véhicule automobile, comprenant une pluralité de sources lumineuses contrôlables sélectivement ; un substrat présentant des première et deuxième faces opposées, ladite pluralité de sources lumineuses étant montées sur la première face du substrat et un contrôleur apte à contrôler sélectivement chacune desdites sources lumineuses, **caractérisé en ce que** le contrôleur est encapsulé dans un boîtier présentant des première et deuxième faces opposées, le boîtier étant monté, via sa première face, sur la deuxième face du substrat, dans lequel le boîtier comporte une embase métallique formant la deuxième face du boîtier, le contrôleur étant monté sur l'embase métallique, le boîtier comportant un système d'interconnexion relié directement au contrôleur et agencé pour interconnecter le contrôleur au substrat et à la pluralité de sources lumineuses et une pluralité de trous métallisés chacun relié directement à l'embase métallique et débouchant sur la première face du boîtier pour être relié au substrat.

2. Module lumineux selon la revendication précédente, dans lequel le système d'interconnexion comporte une pluralité de micro-vias agencés pour transférer des signaux électriques émis par le contrôleur et destinés à contrôler sélectivement ladite pluralité de sources lumineuses vers le substrat.

3. Module lumineux selon la revendication précédente, dans lequel le système d'interconnexion comporte une pluralité de couches superposées entre le contrôleur et la première face du boîtier, chaque couche comportant une pluralité de micro-vias connectés avec des micro-vias des couches adjacentes.

4. Module lumineux selon l'une des revendications précédentes, dans lequel le système d'interconnexion est relié au contrôleur uniquement au niveau d'une face du contrôleur opposée à la face de montage du contrôleur sur l'embase métallique.

5. Module lumineux selon l'une des revendications précédentes, dans lequel le système d'interconnexion comporte une matrice de connecteurs formée sur la deuxième face du boîtier, chaque connecteur étant relié électriquement au substrat.

6. Module lumineux selon l'une des revendications précédentes, dans lequel l'embase métallique comporte un renfoncement dans lequel est monté le contrôleur.

7. Module lumineux selon l'une des revendications précédentes, dans lequel au moins l'un desdits trous métallisés est relié à une masse du substrat.

8. Module lumineux selon l'une des revendications précédentes, dans lequel au moins deux desdits trous métallisés débouchent sur la première face du boîtier au niveau d'un même connecteur auquel ces trous métallisés sont électriquement reliés.

9. Module lumineux selon l'une des revendications précédentes, **caractérisé en ce qu'**il comprend un organe de dissipation thermique sur lequel est monté ledit boîtier via sa deuxième face.

10. Module lumineux selon la revendication précédente, dans lequel chacune des sources lumineuses comporte au moins une puce à semi-conducteur émettrice de lumière dont les dimensions sont comprises entre 150 µm et 400 µm.

11. Module lumineux selon la revendication précédente, dans lequel chacune des sources lumineuses comporte au moins une puce à semi-conducteur émettrice de lumière dont les dimensions sont comprises entre 5 µm et 150 µm.

12. Module lumineux selon l'une des revendications précédentes, **caractérisé en ce qu'**il comporte un connecteur pour recevoir une instruction de contrôle de ladite pluralité de sources lumineuses, dans lequel la pluralité de sources lumineuses forme une matrice passive et dans lequel le contrôleur est agencée pour contrôler ladite matrice passive en fonction de l'instruction de contrôle reçue par le connecteur.

13. Dispositif de signalisation d'un véhicule automobile, **caractérisé en ce qu'**il comporte un module lumineux selon l'une des revendications précédentes, ladite pluralité de sources lumineuses formant un écran lumineux dudit dispositif de signalisation.

## Patentansprüche

1. Lichtmodul einer Signalisierungsvorrichtung eines Kraftfahrzeugs, umfassend eine Vielzahl von selektiv steuerbaren Lichtquellen; ein Substrat mit einer ersten und einer zweiten gegenüberliegenden Fläche, wobei die Vielzahl von Lichtquellen auf der ersten Fläche des Substrats montiert ist, und einen Controller, der geeignet ist, jede der Lichtquellen selektiv zu steuern, **dadurch gekennzeichnet, dass** der Controller in einem Gehäuse mit einer ersten und einer zweiten gegenüberliegenden Fläche eingekapselt ist, wobei das Gehäuse über seine erste Fläche auf der zweiten Fläche des Substrats montiert ist, wobei das Gehäuse eine metallische Basis aufweist, die die zweite Fläche des Gehäuses bildet, der Controller auf der metallischen Basis montiert ist, das Gehäuse ein Verbindungssystem aufweist, das direkt mit dem Controller verbunden und dazu angeordnet ist, den Controller mit dem Substrat und der Vielzahl von Lichtquellen zu verbinden, sowie eine Vielzahl von metallisierten Löchern, die jeweils direkt mit der metallischen Basis verbunden sind und auf der ersten Fläche des Gehäuses münden, um mit dem Substrat verbunden zu werden.

2. Lichtmodul nach dem vorhergehenden Anspruch, bei dem das Verbindungssystem eine Vielzahl von Mikrovias umfasst, die dazu angeordnet sind, vom Controller ausgesendete elektrische Signale, die zur selektiven Steuerung der Vielzahl von Lichtquellen bestimmt sind, zum Substrat zu übertragen.

3. Lichtmodul nach dem vorhergehenden Anspruch, bei dem das Verbindungssystem eine Vielzahl von übereinander angeordneten Schichten zwischen dem Controller und der ersten Fläche des Gehäuses umfasst, wobei jede Schicht eine Vielzahl von Mikrovias aufweist, die mit Mikrovias der benachbarten Schichten verbunden sind.

4. Lichtmodul nach einem der vorhergehenden Ansprüche, bei dem das Verbindungssystem mit dem Controller ausschließlich an einer Fläche des Controllers verbunden ist, die der Montagefläche des Controllers auf der metallischen Basis gegenüberliegt.

5. Lichtmodul nach einem der vorhergehenden Ansprüche, bei dem das Verbindungssystem eine auf der zweiten Fläche des Gehäuses ausgebildete Verbindermatrix umfasst, wobei jeder Verbinder elektrisch mit dem Substrat verbunden ist.

6. Lichtmodul nach einem der vorhergehenden Ansprüche, bei dem die metallische Basis eine Vertiefung aufweist, in der der Controller montiert ist.

7. Lichtmodul nach einem der vorhergehenden Ansprüche, bei dem mindestens eines der metallisierten Löcher mit einer Masse des Substrats verbunden ist.

8. Lichtmodul nach einem der vorhergehenden Ansprüche, bei dem mindestens zwei der metallisierten Löcher auf der ersten Fläche des Gehäuses an einem gemeinsamen Verbinder münden, mit dem diese metallisierten Löcher elektrisch verbunden sind.

9. Lichtmodul nach einem der vorhergehenden Ansprüche, **dadurch gekennzeichnet, dass** es ein Wärmeabführungselement umfasst, auf dem das Gehäuse über seine zweite Fläche montiert ist.

10. Lichtmodul nach dem vorhergehenden Anspruch, bei dem jede der Lichtquellen mindestens einen lichtemittierenden Halbleiterchip umfasst, dessen Abmessungen zwischen 150 µm und 400 µm liegen.

11. Lichtmodul nach dem vorhergehenden Anspruch, bei dem jede der Lichtquellen mindestens einen lichtemittierenden Halbleiterchip umfasst, dessen Abmessungen zwischen 5 µm und 150 µm liegen.

12. Lichtmodul nach einem der vorhergehenden Ansprüche, **dadurch gekennzeichnet, dass** es einen Verbinder zum Empfangen einer Steueranweisung für die Vielzahl von Lichtquellen aufweist, wobei die Vielzahl von Lichtquellen eine passive Matrix bildet und der Controller dazu angeordnet ist, die passive Matrix in Abhängigkeit von der durch den Verbinder empfangenen Steueranweisung zu steuern.

13. Signalisierungsvorrichtung eines Kraftfahrzeugs, **dadurch gekennzeichnet, dass** sie ein Lichtmodul nach einem der vorhergehenden Ansprüche umfasst, wobei die Vielzahl von Lichtquellen einen Leuchtbildschirm der Signalisierungsvorrichtung bildet.

## Claims

1. A luminous module of a signalling device of an automotive vehicle, comprising a plurality of selectively controllable light sources; a substrate having first and second opposing faces, said plurality of light sources being mounted on the first face of the substrate, and a controller capable of selectively controlling each of said light sources, **characterised in that** the controller is encapsulated in a housing having first and second opposing faces, the housing being mounted, via its first face, on the second face of the substrate, wherein the housing comprises a metal base forming the second face of the housing, the controller being mounted on the metal base, the housing comprising an interconnection system connected directly to the controller and arranged to interconnect the controller to the substrate and to the plurality of light sources, and a plurality of metallised holes each connected directly to the metal base and opening onto the first face of the housing so as to be connected to the substrate.

2. The luminous module according to the preceding claim, wherein the interconnection system comprises a plurality of micro-vias arranged to transfer electrical signals emitted by the controller and intended to selectively control said plurality of light sources towards the substrate.

3. The luminous module according to the preceding claim, wherein the interconnection system comprises a plurality of superimposed layers between the controller and the first face of the housing, each layer comprising a plurality of micro-vias connected to micro-vias of adjacent layers.

4. The luminous module according to one of the preceding claims, wherein the interconnection system is connected to the controller only at a face of the controller opposite to the mounting face of the controller on the metal base.

5. The luminous module according to one of the preceding claims, wherein the interconnection system comprises a matrix of connectors formed on the second face of the housing, each connector being electrically connected to the substrate.

6. The luminous module according to one of the preceding claims, wherein the metal base comprises a recess in which the controller is mounted.

7. The luminous module according to one of the preceding claims, wherein at least one of said metallised holes is connected to a ground of the substrate.

8. The luminous module according to one of the preceding claims, wherein at least two of said metallised holes open onto the first face of the housing at a same connector to which these metallised holes are electrically connected.

9. The luminous module according to one of the preceding claims, **characterised in that** it comprises a heat dissipation member on which said housing is mounted via its second face.

10. The luminous module according to the preceding claim, wherein each of the light sources comprises at least one light-emitting semiconductor chip whose dimensions are between 150 µm and 400 µm.

11. The luminous module according to the preceding claim, wherein each of the light sources comprises at least one light-emitting semiconductor chip whose dimensions are between 5 µm and 150 µm.

12. A luminous module according to one of the preceding claims, **characterised in that** it comprises a connector for receiving a control instruction for said plurality of light sources, wherein the plurality of light sources forms a passive matrix and wherein the controller is arranged to control said passive matrix according to the control instruction received by the connector.

13. A signalling device of an automotive vehicle, **characterised in that** it comprises a luminous module according to one of the preceding claims, said plurality of light sources forming a luminous screen of said signalling device.
